# EUROPÄISCHE PATENTSCHRIFT

(11) **EP 2 285 199 B1**
(45) Veröffentlichungstag und Bekanntmachung des Hinweises auf die Patenterteilung: **21.11.2012**
(21) Anmeldenummer: 09167617.1
(22) Anmeldetag: 11.08.2009
(51) Int. Cl.: H05K 7/20, H05K 7/14

(54) **Modulare Vorrichtung und Baugruppe**
Modular device and component
Dispositif et composant modulaires

(43) Veröffentlichungstag der Anmeldung: 16.02.2011
(73) Patentinhaber: SIEMENS AKTIENGESELLSCHAFT, 80333 München (DE)
(72) Erfinder: Rohne, Klaus, 09350 Lichtenstein (DE); Chowaniec, Michael, 09126 Chemnitz (DE); Schwabe, Dietmar, 08496 Neumark (DE)

(56) Entgegenhaltungen:
- EP-A1- 1 739 804
- US-A- 3 956 673
- US-A- 4 931 904
- US-A1- 2005 006 053

## Beschreibung

Die Erfindung betrifft eine modulare Vorrichtung umfassend eine Tragschiene, eine erste Baugruppe und eine zweite Baugruppe, wobei die Baugruppen auf der Tragschiene angeordnet sind, wobei die Tragschiene ein Profil aufweist, welches ausgestaltet ist die Baugruppen an einer den Baugruppen zugehörigen Rückwand zu befestigen.

Des Weiteren betrifft die Erfindung eine Baugruppe zum Befestigen auf einer Tragschiene, umfassend ein Gehäuse, wobei das Gehäuse dazu ausgebildet ist an der Tragschiene befestigt zu sein.

Modular aufbaubare Vorrichtungen, umfassend mehrere Baugruppen, welche an einer Tragschiene, beispielsweise einer Profilschiene aus Metall, insbesondere einer Hutschiene, befestigt sind, sind beispielsweise aus folgendem Stand der Technik bekannt: EP 0 740 499 A1, DE 10 2004 056 243 A1, US 4,829,402 A1, DE 32 02 271 A1 und DE 35 09 908 A1.

Die DE 10 2004 056 243 A1 offenbart im Wesentlichen eine Vorrichtung, welche dazu ausgestaltet ist ein modulares Automatisierungssystem aufzubauen und eine Anordnung von Baugruppen und Automatisierungskomponenten optimiert auszugestalten. Die weiteren genannten Schriften befassen sich hingegen mit Kühlvorrichtungen, Vorrichtungen zum Abführen von Verlustwärme und einer Befestigung von Baugruppen an einer Hutschiene im Hinblick auf eine Kühlkörperanbindung.

Beim Aufbau von modular aneinanderreihbaren Baugruppen, vorzugsweise zum Zusammenstellen eines Automatisierungsgerätes für die Automatisierung eines industriellen Prozesses, steht ein Inbetriebsetzer oder ein Monteur vor der Problematik, die durch die elektrischen Baugruppen entstehende Verlustwärme abzuführen. In der DE 32 02 271 A1 wird dazu vorgeschlagen, die Baugruppen an einer Tragschiene zu befestigen, wobei die Tragschiene ein als Wärmerohr ausgebildetes geschlossenes metallisches Hohlprofil aufweist. Die EP 0 740 499 A1 stellt als Lösungsvorschlag eine Kühlkörperanbindung an die Hutschiene bereit. In der DE 35 09 908 A1 ist ein Kühlrohr in einen Baugruppenträger derart angeordnet, dass er mit einer Vorrichtung, welche Kühldüsen aufweist, verbunden werden kann, wobei die Kühldüsen auf Wärmenester ausgerichtet sind.

In der US 3,956,673 A sind Baugruppen zwischen zwei Tragschienen angeordnet, wobei eine Tragscheine die Baugruppen mit einer Zuluft versorgt und eine andere Tragschiene die Zuluft entsorgt.

Nachteilig an dem aufgezeigten Stand der Technik ist es, dass die offenbarten Vorrichtungen konstruktiv aufwendig zu gestalten sind.

Es ist daher die Aufgabe der Erfindung eine modulare Vorrichtung bereitzustellen, bei welcher eine aktive Kühlung der Baugruppen auf eine Art und Weise gelöst wird, bei welcher der konstruktive Aufwand möglichst gering gehalten wird.

Die Aufgabe wird dadurch gelöst, dass bei der eingangs genannten modularen Vorrichtung zwischen der Rückwand und der Tragschiene ein Raum gebildet ist und die erste Baugruppe dazu ausgestaltet ist einen Überdruck in dem Raum zu erzeugen, wobei die zweite Baugruppe derart ausgestaltet ist, dass durch den Überdruck ein in dem Raum befindliches Medium zur Kühlung in das Innere der zweiten Baugruppe strömt. Die Rückwände der Baugruppen sind demnach derart ausgestaltet, dass ein Kühlmedium, beispielsweise Luft, durch die Rückwand in den Raum, welcher durch die Abdeckung der Baugruppe auf einen Kanal der Tragschiene gebildet wird, in diesen Einströmen bzw. aus diesem Ausströmen kann. Wird beispielsweise als Tragschiene eine Hutschiene mit U-förmigen bzw. einem hutähnlichen Profil eingesetzt, so ist durch das U-förmige Profil eine Basis für einen späteren Strömungskanal gegeben. Durch die Abdeckung des U-Profils mit den Rückwänden der Baugruppen wird ein Strömungskanal gebildet. Für das Zusammenstellen einer modularen Vorrichtung aus einzelnen Baugruppen auf der Tragschiene stehen dann vorzugsweise zwei Arten von Baugruppen bereit, eine erste Art von Baugruppen kann als aktive Kühlungsbaugruppe bezeichnet werden und weist als Mittel zur Erzeugung eines Überdruckes beispielsweise einen Radiallüfter oder einen synthetischen Jetantrieb auf. Auch ist es denkbar, dass die Baugruppe einen Druckluftanschluss aufweist, an diesen Anschluss könnten dann ein, in den meisten Fällen sowieso im industriellen Umfeld vorhandener, Druckluftschlauch angeschlossen werden. Je nach Kühlbedarf bzw. einer durch die Tragschiene strömenden Luftmenge könnte die Baugruppe weiterhin einen Druckminderer aufweisen.

Die zweite Art von Baugruppen kann als Standardbaugruppen bezeichnet werden, dies sind in der Regel Baugruppen, welche elektrische Verlustwärme erzeugen. Der durch die Kühlungsbaugruppen erzeugte Überdruck lässt das Medium, beispielsweise Luft, in den Strömungskanal strömen und wird durch diesen weitergeleitet zu den Standardbaugruppen. Die Standardbaugruppen sind mit ihrer Rückwand ausgestaltet um den erzeugten Luftstrom in das Innere der Baugruppe zu leiten. Durch das gegenseitige Zusammenwirken von Tragschiene und entsprechend ausgestalteten Rückwänden der Baugruppen wird somit auf einfache Art und Weise ein Belüftungskanal bereitgestellt, welcher zum Kühlen der Baugruppen genutzt wird.

In einer besonderen Ausgestaltung der Erfindung sind die Baugruppen derart ausgestaltet, dass durch eine Aneinanderreihung von Baugruppen auf der Tragschiene ein Strömungskanal für das Medium gebildet ist. Dieser Strömungskanal erstreckt sich dann von einem Anfang des modularen Systems bis zu einem Ende des modularen Systems. Der Strömungskanal liegt im Wesentlichen parallel zu einer sich längs erstreckenden Symmetrieachse der Tragschiene.

Zweckmäßig ist es, dass die Baugruppen ein Gehäuse mit einem Durchgang für das Medium in der Rückwand aufweisen.

Weiterhin vorteilhaft ist es, dass ein Dichtelement, zwischen Tragschiene und Baugruppe angeordnet ist. Dieses Dichtelement kann beispielsweise als ein Dichtungsstopfen am Anfang der modularen Vorrichtung zwischen der Tragschiene und der ersten Baugruppe derart angeordnet sein, dass der durch das U-Profil und die Rückwand gebildete Hohlraum abgedichtet wird. Ebenso ist sinnvoller Weise am Ende der aus den einzelnen Baugruppen aufgebauten modularen Vorrichtung ebenfalls ein Dichtungsstopfen angeordnet. Der Strömungskanal erstreckt sich sodann von dem einen Dichtungsstopfen zu dem anderen Dichtungsstopfen.

Auch ist es vorteilhaft, wenn die Tragschiene beispielsweise mit Befestigungselementen an einer Wand angebracht ist, wobei zwischen einem Befestigungselement welches die Tragschiene zur Befestigung an der Wand durchdringt, ein weiteres Dichtelement angeordnet ist.

Zur Optimierung einer Kühlleistung sind in dem Gehäuse weitere Durchgangsöffnungen zum Durchströmen des Mediums durch die Baugruppe angeordnet. Vorzugsweise weisen die Baugruppen dazu mehrere Lufteintrittsöffnungen auf.

Die eingangs genannte Aufgabe wird auch durch eine Baugruppe mit den Merkmalen des Anspruchs 7 gelöst. Bei dieser Art von Baugruppe ist es vorteilhaft, dass die Baugruppe mit einem Standardgehäuse bereitgestellt werden kann, dieses Standardgehäuse weist den Durchbruch an seiner Rückwand auf, wobei dieses Standardgehäuse für den Aufbau einer aktiven Kühlungsbaugruppe genutzt wird, in dem in das Gehäuse ein Mittel zum Erzeugen eines Überdruckes integriert ist. Das Mittel, welches beispielsweise ein Radiallüfter ist, sorgt dafür, dass, beispielsweise Luft, durch den Durchgang in das U-Profil der Tragschiene strömt.

Das gleiche Gehäuse kann aber auch dafür genutzt werden um mit diesem Gehäuse eine Baugruppe aufzubauen, welcher auf-ihrer Ausgestaltung mit elektrischen Komponenten Verlustwärme erzeugt. Durch den gleichen Durchgang kann nun die mit der aktiven Kühlungsbaugruppe erzeugte strömende Luft in die Baugruppe, welche Verlustwärme erzeugt, geführt werden und diese dadurch gekühlt werden.

Anhand der Zeichnung werden ein Ausführungsbeispiel und weitere Merkmale und Vorteile der Erfindung aufgezeigt. Es zeigen:
- FIG 1: eine modulare Vorrichtung,
- FIG 2: eine Baugruppe, angeordnet auf einer Tragschiene, mit Dichtelement schematisch dargestellt,
- FIG 3: eine Baugruppe in Seitenansicht, angeordnet auf ei- ner Tragschiene, mit Kühlluftströmen und
- FIG 4: eine Baugruppe in Seitenansicht, angeordnet auf ei- ner Tragschiene, mit Abwärmeströmen.

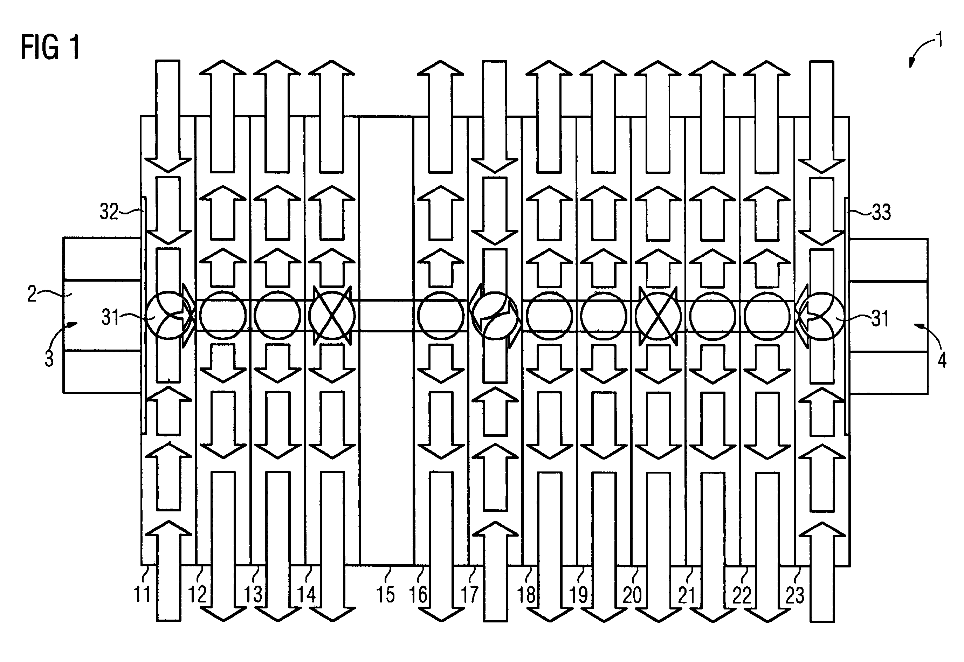

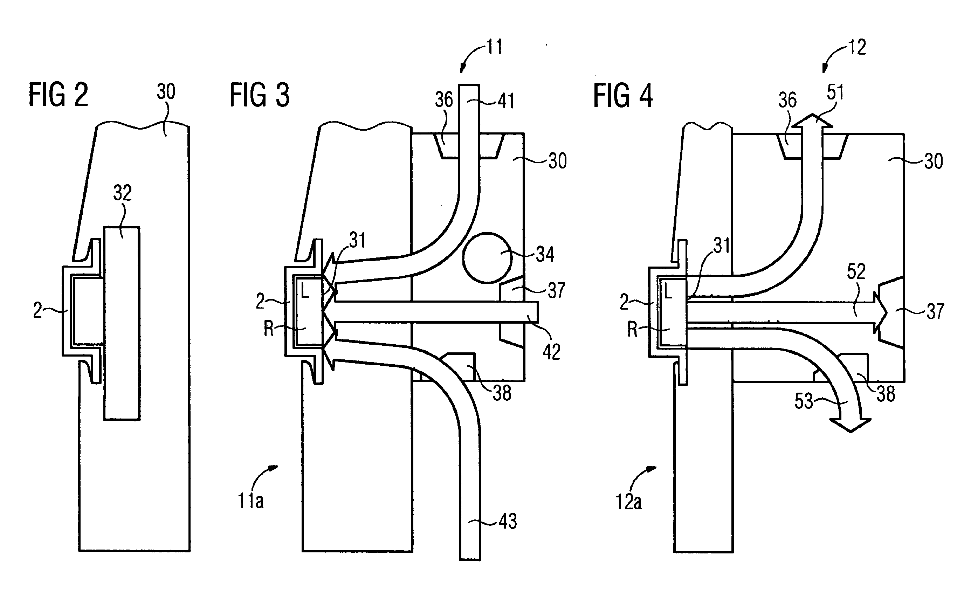

Gemäß FIG 1 ist eine modulare Vorrichtung 1 umfassend eine Tragschiene 2, eine erste Baugruppe 11 und eine zweite Baugruppe 12, wobei die Baugruppen 11,12 auf der Tragschiene 2 angeordnet sind, wobei die Tragschiene 2 ein Profil aufweist, welches ausgestaltet ist die Baugruppen 11,12 an einer den Baugruppen 11,12 zugehörigen Rückwand 11a,12a (siehe FIG 3 und FIG 4) zu befestigen.

Die modulare Vorrichtung 1 ist ein Automatisierungssystem mit einzelnen Automatisierungskomponenten als einzelne Baugruppen. Von einem Anfang 3 ausgehend bis zu einem Ende 4 ist das Automatisierungssystem in der Zeichnung von links nach rechts gesehen, aus dreizehn einzelnen Baugruppen 11,...,23 aufgebaut. Der Aufbau fängt am Anfang 3 mit der ersten Baugruppe 11 an und schließt mit der dreizehnten Baugruppe 23 am Ende 4 ab. Der Aufbau umfasst im Wesentlichen zwei grundsätzliche Arten von Baugruppen, eine aktive Kühlungsbaugruppe und eine Standardbaugruppe, welche gekühlt werden muss.

Die erste Baugruppe 11, die siebte Baugruppe 17 und die dreizehnte Baugruppe 23 sind als aktive Kühlungsbaugruppen ausgestaltet. Diese Baugruppen weisen ein Mittel zum Erzeugen eines Überdruckes auf.

Die weiteren Baugruppen 12,13,14,16,18,19,20,21 und 22 sind als sogenannte Standardbaugruppen ausgestaltet, wobei diese Standardbaugruppen Verlustwärme erzeugen, welche durch, durch die Kühlungsbaugruppen erzeugte Luftströme, abgeführt wird. Die Luftströme sind in der FIG 1 symbolisch durch Pfeile angedeutet. Da die erste Baugruppe 11 als eine Kühlungsbaugruppe ausgestaltet ist, saugt sie von außen Luft an und drückt diese Kühlluft durch einen Durchgang 31 in den Raum zwischen Baugruppenrückwand und Profil der Tragschiene 2. Aus der zweiten, dritten und vierten Baugruppe 12,13,14 kann die erzeugte Kühlluft zur Kühlung der Baugruppen wieder ausströmen. Die fünfte Baugruppe 15 ist als eine Baugruppe ausgestaltet, welche einer Kühlung nicht bedarf. Die Rückwand der fünften Baugruppe 15 ist derart ausgestaltet, dass eine durch das U-Profil strömende Luft nicht behindert wird. Die fünfte Baugruppe 15 weist in ihrer Rückwand demnach keinen Durchgang auf, es kann also auch keine Kühlluft in diese einströmen. Die Baugruppen 19 bis 22 sind eingerahmt durch die siebte Baugruppe 17 und die dreizehnte Baugruppe 23, da die siebte Baugruppe 17 eine aktive Kühlungsbaugruppe und auch die dreizehnte Baugruppe 23 eine aktive Kühlungsbaugruppe ist, wird durch die Baugruppen 19 bis 22 von beiden Seiten ein Lüftungsstrom erzwungen, welcher durch die Baugruppen, durch die Pfeile angedeutet, wieder abströmen kann.

Die Aneinanderreihung der Baugruppen 11 bis 23 weist am Anfang 3 ein Dichtelement 32 auf. Auch das Ende 4 der Aneinanderreihung der Baugruppen ist mit einem weiteren zweiten Dichtelement 33 abgeschlossen. Das erste Dichtelement 32 und zweite Dichtelement 33 verhindern dadurch ein ungewolltes Abströmen der durch die aktiven Kühlungsbaugruppen erzeugten Kühlluft.

Gemäß FIG 2 ist schematisch eine Baugruppe in Seitenansicht auf einer Tragschiene 2 dargestellt. Die Baugruppe weist ein Gehäuse 30 auf, welches an der Rückwand des Gehäuses derart ausgestaltet ist, dass Verrastnasen zur Befestigung der Baugruppe auf der Tragschiene 2 angeordnet sind. Um den durch die Rückwand der Baugruppe und dem U-förmigen Profil der Tragschiene gebildeten Raum bzw. Strömungskanal abzudichten, ist das erste Dichtelement 32 derart ausgeformt, dass es genau in das U-förmige Profil der Tragschiene 2 passt und die seitliche Rückwandbegrenzung der Baugruppe derart abdichtet, dass keine Kühlluft mehr ausströmen kann.

Die FIG 3 zeigt die erste Baugruppe 11 in schematischer Seitenansicht. Die erste Baugruppe 11 ist wiederum auf einer Tragschiene 2 mit Hilfe der am Gehäuse 30 vorgesehenen Verrastnasen angeordnet. Ein Teil der ersten Rückwand 11a bildet zusammen mit dem U-förmigen Profil der Tragschiene 2 einen Raum R in den ein erster Kühlluftstrom 41, ein zweiter Kühlluftstrom 42 und ein dritter Kühlluftstrom 43 einströmen kann. Die Kühlluftströme 41,42,43 werden durch ein Mittel 34 zur Erzeugung eines Überdruckes hervorgerufen. Das Mittel 34 ist beispielsweise als ein Radiallüfter innerhalb des Gehäuses 30 angeordnet. Damit die Kühlluftströme 41,42,43 strömen können, sind in dem Gehäuse 30 eine erste Durchgangsöffnung 36, eine zweite Durchgangsöffnung 37 und eine dritte Durchgangsöffnung 38 angeordnet.

Analog zu der FIG 3 zeigt die FIG 4 nun die zweite Baugruppe 12 mit einer zweiten Rückwand 12a. Die Gehäuse 30 sind für die erste Baugruppe 11 aus FIG 3 und für die zweite Baugruppe 12 aus FIG 4 identisch ausgestaltet. Als Unterschied zwischen der ersten Baugruppe 11 und zweiten Baugruppe 12 sind Mittel zur Erzeugung eines Überdruckes nicht vorhanden. Die Baugruppe 12 ist vielmehr als eine Baugruppe ausgestaltet, welche aufgrund ihrer inneren Ausgestaltung durch elektrische Betriebsmittel Verlustwärme erzeugt. Bezugnehmend auf FIG 1 ist die erste Baugruppe 11 als eine aktive Kühlungsbaugruppe ausgestaltet und sorgt damit dafür, dass ein Kühlluftstrom 41,42,43 in den Raum R gedrückt wird, wobei der Kühlluftstrom in den durch die Tragschiene 2 und der Summe der Rückwände 11a,12agebildeten Strömungskanal zu der benachbarten zweiten Baugruppe 12 strömen kann und durch diese als eine erwärmte Kühlluft ausströmen kann.

FIG 4 zeigt einen ersten Abwärmestrom 51, welcher durch die erste Durchgangsöffnung 36 abströmen kann. Der zweite Abwärmestrom 52 strömt durch die zweite Durchgangsöffnung 37 und der dritte Abwärmestrom 53 strömt durch die dritte Durchgangsöffnung 38 ab. Die zweite Baugruppe 12 wird durch das Abströmen der Abwärmeströme 51,52,53 entwärmt und somit gekühlt.

Für vorzugsweise aufgerastete Baugruppen an einer Tragschiene, wie beispielsweise einer 35mm Standard-Hutschiene, aber auch anderen Schienen, welche dazu geeignet sind einen Strömungskanal zu bilden, wie beispielsweise eine G-Schiene, wird das Profil als ein Belüftungskanal genutzt. Belüftungsmodule oder Kühlungsmodule können somit Kühlluft in den Innenraum der Schiene, welcher durch Dichtelementen an den Enden der Kühlstrecken verschlossen ist, einblasen.

Eine Anzahl an einzusetzenden Kühlungsmodulen kann nun frei variiert werden und hängt vom Kühlbedarf des gesamten modular aufgebauten Automatisierungssystems ab.

## Patentansprüche

1. Modulare Vorrichtung (1) umfassend
- eine Tragschiene (2),
- eine erste Baugruppe (11) und eine zweite Baugruppe (12), wobei die Baugruppen (11,12) auf der Tragschiene (2) angeordnet sind,
wobei die Tragschiene (2) ein Profil aufweist, welches ausgestaltet ist die Baugruppen (11, 12) an einer den Baugruppen (11, 12) zugehörigen Rückwand (11a, 12a) zu befestigen,
**dadurch gekennzeichnet, dass** zwischen der Rückwand (11a, 12a) und der Tragschiene (2) ein Raum (R) gebildet ist und die erste Baugruppe (11) dazu ausgestaltet ist einen Überdruck in dem Raum (R) zu erzeugen, wobei die zweite Baugruppe (12) derart ausgestaltet ist, dass durch den Überdruck ein in dem Raum (R) befindliches Medium (L) zur Kühlung in das Innere der zweiten Baugruppe (12) strömt.

2. Modulare Vorrichtung (1) nach Anspruch 1, wobei die Baugruppen (11, 12) ausgestaltet sind, dass durch eine Aneinanderreihung von Baugruppen (11,12) auf der Tragschiene (2) ein Strömungskanal für das Medium (L) gebildet ist.

3. Modulare Vorrichtung (1) nach Anspruch 1 oder 2, wobei die Baugruppen (11, 12) ein Gehäuse (30) mit einem Durchgang (31) für das Medium (L) in der Rückwand (11a,12a) aufweisen.

4. Modulare Vorrichtung (1) nach einem der Ansprüche 1 bis 3, aufweisend ein Dichtelement (32,33), welches zwischen Tragschiene (2) und Baugruppe (11, 12) angeordnet ist.

5. Modulare Vorrichtung (1) nach einem der Ansprüche 1 bis 4, wobei zwischen einem Befestigungselement, welches die Tragschiene (2) zur Befestigung an einer Wand durchdringt, ein weiteres Dichtelement angeordnet ist.

6. Modulare Vorrichtung (1) nach einem der Ansprüche 3 bis 5, wobei in dem Gehäuse (30) weitere Durchgangsöffnungen (36,37,38) zum Durchströmen des Mediums (L) durch die Baugruppe (11,12) angeordnet sind.

7. Baugruppe (12) zum Befestigen auf einer Tragschiene (2), umfassend ein Gehäuse (30), wobei das Gehäuse (30) dazu ausgebildet ist an der Tragschiene (2) mechanisch befestigt zu sein, wobei eine Rückwand (11a,12a) des Gehäuses (2) einen zur Tragschiene (2) gerichteten Durchgang (31) aufweist,
**gekennzeichnet durch** ein Mittel (34) zur Erzeugung eines Überdrucks **durch** welchen ein Medium (L) in einen Raum (R) zwischen der Rückwand (11a, 12a) und der Tragschiene (2) **durch** den Durchgang (31) leitbar ist.

## Claims

1. Modular apparatus (1) comprising:
- a mounting rail (2),
- a first assembly (11) and a second assembly (12), wherein the assemblies (11, 12) are arranged on the mounting rail (2)
wherein the mounting rail (2) has a profile which is designed to attach the assemblies (11, 12) to a rear wall (11a, 12a) which is associated with the assemblies (11, 12)
**characterized in that** a space (R) is formed between the rear wall (11a, 12a) and the mounting rail (2) and the first assembly (11) is designed to produce an overpressure in the space (R), wherein the second assembly (12) is designed such that the overpressure results in a medium (L), which is located in the space (R), flowing into the interior of the second assembly (12), for cooling.

2. Modular apparatus (1) according to Claim 1, wherein the assemblies (11, 12) are designed such that the arrangement of assemblies (11, 12) in a row on the mounting rail (2) forms a flow channel for the medium (L).

3. Modular apparatus (1) according to Claim 1 or 2, wherein the assemblies (11, 12) have a housing (30) with a passage (31) for the medium (L) in the rear wall (11a, 12a).

4. Modular apparatus (1) according to one of Claims 1 to 3, having a sealing element (32, 33) which is arranged between the mounting rail (2) and the assembly (11, 12).

5. Modular apparatus (1) according to one of Claims 1 to 4, wherein a further sealing element is arranged between an attachment element, which passes through the mounting rail (2) for attachment to a wall, and the mounting rail.

6. Modular apparatus (1) according to one of Claims 3 to 5, wherein further passage openings (36, 37, 38) are arranged in the housing (30) for the medium (L) to flow through the assembly (11, 12).

7. Assembly (12) for mounting on a mounting rail (2), comprising a housing (30), wherein the housing (30) is designed to be mechanically attached to the mounting rail (2), wherein a rear wall (11a, 12a) of the housing (2) has a passage (31) which is directed to the mounting rail (2), **characterized by** a means (34) for producing an overpressure, by means of which a medium (L) can be passed through the passage (31) into a space (R) between the rear wall (11a, 12a) and the mounting rail (2).

## Revendications

1. Dispositif ( 1 ) modulaire comprenant
- un rail ( 2 ) porteur,
- un premier module ( 11 ) et un deuxième module ( 12 ), les modules ( 11, 12 ) étant montés sur le rail ( 2 ) porteur,
le rail ( 2 ) porteur ayant un profil qui est conformé pour fixer les modules ( 11, 12 ) sur une paroi ( 11a, 12a ) arrière faisant partie des modules ( 11, 12 ),
**caractérisé en ce qu'**un espace ( R ) est formé entre la paroi ( 11a, 12a ) arrière et le rail ( 2 ) porteur et le premier module ( 11 ) est conformé pour produire une surpression dans l'espace ( R ), le deuxième module ( 12 ) étant conformé de manière à ce que, par la surpression, un milieu ( L ) se trouvant dans l'espace ( R ) s'écoule pour le refroidissement à l'intérieur du deuxième module ( 12 ).

2. Dispositif ( 1 ) modulaire suivant la revendication 1, dans lequel les modules ( 11, 12 ) sont conformés de manière à former, en rangeant les modules ( 11, 12 ) les uns à côté des autres sur le rail ( 2 ) porteur, un canal d'écoulement pour le milieu ( L ).

3. Dispositif ( 1 ) modulaire suivant la revendication 1 ou 2, dans lequel les modules ( 11, 12 ) ont un boîtier ( 30 ) ayant un passage ( 31 ) pour le milieu ( L ) dans la paroi ( 11a, 12a ) arrière.

4. Dispositif ( 1 ) modulaire suivant l'une des revendications 1 à 3, comprenant un élément ( 32, 33 ) d'étanchéité qui est disposé entre le rail ( 2 ) porteur et les modules ( 11, 12 ).

5. Dispositif ( 1 ) modulaire suivant l'une des revendications 1 à 4, dans lequel, un autre élément d'étanchéité est disposé entre un élément de fixation, qui, pour la fixation sur une paroi, traverse le rail ( 2 ) porteur.

6. Dispositif ( 1 ) modulaire suivant l'une des revendications 1 à 5, dans lequel d'autres ouvertures ( 36, 37, 38 ) de passage dans le boîtier ( 30 ) sont disposées pour le passage du milieu ( L ) dans les modules ( 11, 12 ).

7. Module ( 12 ) à fixer sur un rail porteur, comprenant un boîtier ( 30 ), le boîtier ( 30 ) étant constitué pour être fixé mécaniquement sur le rail ( 2 ) porteur, une paroi (11a, 12a) arrière du boîtier ( 2 ) ayant un passage ( 31 ) dirigé vers le rail ( 2 ) porteur, **caractérisé par** un moyen ( 34 ) de production d'une surpression par laquelle un fluide ( L ) dans un espace ( R ) compris entre la paroi ( 11a, 12a ) arrière et le rail ( 2 ) porteur peut passer dans le passage ( 31 ).
